# EUROPEAN PATENT APPLICATION

(11) **EP 3 276 823 A1**
(43) Date of publication of application: **31.01.2018**
(21) Application number: 16767992.7
(22) Date of filing: 14.03.2016
(51) Int. Cl.: H02S 40/36, H02S 30/20

(54) **PHOTOELECTRIC CONVERSION DEVICE**

(30) Priority: 23.03.2015 JP 2015059752
(71) Applicant: Zeon Corporation, Tokyo 100-8246 (JP)
(72) Inventor: YOSHIDA, Masayoshi, Tokyo 100-8246 (JP); KOJIMA, Kiyoshige, Tokyo 100-8246 (JP); HAYASHI, Yuki, Tokyo 100-8246 (JP); YAMAAI, Midori, Tokyo 100-8246 (JP); YOSHIWARA, Akihiko, Tokyo 100-8246 (JP)
(74) Representative: Maiwald Patentanwalts GmbH
(86) International application number: PCT/JP2016/001440
(87) International publication number: WO 2016/152084

(57) **Abstract**

Provided is a photoelectric conversion device that facilitates the addition of solar cell module groups and enables improvement of convenience. The photoelectric conversion device includes an interface (21) and is configured to receive an electrical power supply from at least one solar cell module group (10) attached to the interface (21). The interface (21) includes a plurality of rigid members (211), each including a second connection unit (215) that is mechanically and electrically linkable to a first connection unit (123) of the solar cell module group (10), and one or more linking portions (216) that mechanically and electrically link the rigid members (211) in a foldable manner.

## Description

### TECHNICAL FIELD

This disclosure relates to a photoelectric conversion device.

### BACKGROUND ART

In recent years, there has been increased demand for portable power generating devices that enable users to use portable devices such as smartphones, notebook personal computers (PCs), and tablet PCs even when they go out and do not have access to a commercial power supply.

In one example, PTL 1 discloses a sheet-shaped structure in which a plurality of solar cells arranged with a specific spacing therebetween (solar cell module) and a flexible conductive member that connects electrodes of the solar cells are sandwiched from above and below by sheet-shaped transparent film members that are flexible and elastic. According to such a sheet-shaped structure, when in use the sheet-shaped structure is spread out and electrical power generated by the solar cells can be extracted and used by an external device. Moreover, when not in use the sheet-shaped structure can be folded to facilitate storage and transport.

### CITATION LIST

### Patent Literature

PTL 1: JP H9-51118 A

### SUMMARY

### (Technical Problem)

As mentioned above, the sheet-shaped structure disclosed in PTL 1 has a configuration in which a pre-determined, specific number of solar cells form an integrated structure. Consequently, the electrical power that can be obtained from the sheet-shaped structure is pre-determined dependent on the number and performance of the solar cells included in the sheet-shaped structure. Moreover, the number and size of the solar cells included in the sheet-shaped structure is limited from a viewpoint of weight. Accordingly, the sheet-shaped structure disclosed in PTL 1 is inadequate in terms of convenience because the electrical power that is obtained therewith cannot be adjusted and thus it may not be possible to meet the required electrical power with the sheet-shaped structure.

In a situation in which the required electrical power cannot be met with one sheet of the sheet-shaped structure disclosed in PTL 1, it may be possible to connect a plurality of such sheet-shaped structures to a device and supply electrical power from these sheet-shaped structures. In the case of the sheet-shaped structure disclosed in PTL 1, electrical power can be extracted from the solar cells by connecting the leads, the one end of the leads are connected to the solar cells, and these leads sandwiched from above and below by the transparent film members such as to be secured in place are drawing out from the sheet-shaped structure, and the other end of these leads are connected to a device.

Consequently, in a situation in which a plurality sheet-shaped structure is used, it is necessary to connect leads drawn out from each of the sheet-shaped structures to the device. This is inconvenient because it increases the complexity and length of wiring.

An objective of this disclosure is to solve the problems set forth above and provide a photoelectric conversion device that facilitates addition of solar cell module groups and enables improvement of convenience.

### (Solution to Problem)

The inventors conducted diligent investigation with the aim of solving the problems set forth above. Through this investigation, the inventors conceived an idea of mechanically and electrically linking, in a foldable manner, rigid members that are connectable to solar cell module groups, to facilitate addition of solar cell module groups and enable improvement of convenience.

This disclosure aims to advantageously solve the problems set forth above by disclosing a photoelectric conversion device comprising an interface to which at least one photoelectric conversion module group is attached and configured to receive an electrical power supply from the photoelectric conversion module group that is attached to the interface, wherein the interface includes: a plurality of rigid members, each including a second connection unit that is mechanically and electrically linkable to a first connection unit of the photoelectric conversion module group; and a plurality of linking portions that mechanically and electrically link the rigid members in a foldable manner. By mechanically and electrically linking, in a foldable manner, the rigid members each including a second connection unit that is mechanically and electrically linkable with a first connection unit of a photoelectric conversion module group, it is possible to attach a plurality of photoelectric conversion module groups (i.e., add photoelectric conversion module groups), and thereby improve convenience. Moreover, because the interface is foldable in terms of rigid member units, when not in use the interface can be folded to a smallest unit (width of one rigid member) and stored in a small form. Therefore, the photoelectric conversion device has excellent portability and enables improvement of convenience.

With the aim of advantageously solving the problems set forth above, in the presently disclosed photoelectric conversion device, it is preferable that the photoelectric conversion module group includes a plurality of photoelectric conversion modules in cascade connection and is foldable between adjacent photoelectric conversion modules. In this configuration, the photoelectric conversion module group is also foldable in terms of photoelectric conversion module units, and thus when the interface and each photoelectric conversion module group attached to the interface are folded, it is possible to reduce the two-dimensional (planar) size to be roughly equivalent to a smallest unit of folding of the photoelectric conversion module group (i.e., one photoelectric conversion module). Therefore, the photoelectric conversion device has excellent portability and enables improvement of convenience. Moreover, since the two-dimensional size when the interface and each photoelectric conversion module group attached to the interface are folded is not dependent on the number of rigid members that are included, it is possible to suppress an increase in device size even when the number of rigid members increases.

With the aim of advantageously solving the problems set forth above, in the presently disclosed photoelectric conversion device, it is preferable that the second connection unit is disposed at a surface that, in a state in which adjacent rigid members are folded, is not a surface at which the adjacent rigid members oppose one another. This configuration enables a thinner form when the interface is folded.

With the aim of advantageously solving the problems set forth above, in the presently disclosed photoelectric conversion device, it is preferable that the rigid members each have a thickness that is roughly equivalent to a thickness of a photoelectric conversion module group attached thereto when the photoelectric conversion module group is folded. In this configuration, when a photoelectric conversion module group is attached to each of the rigid members of the interface, the interface and the photoelectric conversion modules are of roughly equivalent thickness in a state in which the interface and each of the photoelectric conversion modules are folded. This enables improvement of portability and storability. Moreover, the thickness of the interface and the photoelectric conversion modules when folded can be reduced as development of thinner photoelectric conversion modules progresses.

With the aim of advantageously solving the problems set forth above, in the presently disclosed photoelectric conversion device, it is preferable that the second connection unit includes: a second connecting portion that is configured to slide against and engage with a first connecting portion of the first connection unit; and a second connector that is configured to connect to a first connector of the first connection unit in a state in which the first connecting portion is at a specific position. This configuration enables mechanical and electrical connection of the photoelectric conversion module group and the rigid member through a simple operation of sliding and engaging the first connecting portion and the second connecting portion.

With the aim of advantageously solving the problems set forth above, in the presently disclosed photoelectric conversion device, it is preferable that one of the first connecting portion and the second connecting portion is a guide rail and the other of the first connecting portion and the second connecting portion is a guide that slides against and engages with the guide rail. This configuration enables simple and secure attachment of photoelectric conversion modules to the interface.

With the aim of advantageously solving the problems set forth above, in the presently disclosed photoelectric conversion device, it is preferable that the rigid members each have a width that is roughly equivalent to a width of the second connecting portion. In this configuration, the width direction size of the rigid members can be restricted and an increase in two-dimensional size of the interface when folded can be inhibited. Therefore, this configuration enables improvement of portability and facilitates folding operation.

With the aim of advantageously solving the problems set forth above, in the presently disclosed photoelectric conversion device, it is preferable that one of the first connection unit and the second connection unit is a card edge connector and the other of the first connection unit and the second connection unit is an edge connector socket into which the card edge connector is inserted. This configuration enables mechanical and electrical connection of the photoelectric conversion module group and the rigid member through a simple operation of inserting the card edge connector into the edge connector socket.

With the aim of advantageously solving the problems set forth above, the presently disclosed photoelectric conversion device preferably further comprises a first support unit configured to support the photoelectric conversion device in a suspended manner. In this configuration, the photoelectric conversion device can be supported in a suspended manner with photoelectric conversion module groups attached thereto. Therefore, it is not necessary to spread out the photoelectric conversion module groups in a plane on a desk, or the like, which enables space-saving when the photoelectric conversion device is set up.

With the aim of advantageously solving the problems set forth above, the presently disclosed photoelectric conversion device preferably further comprises a second support unit disposed on the interface and configured to support the interface in a state in which the photoelectric conversion device is supported in a suspended manner by the first support unit. This configuration enables distribution of suspension stress that acts on the interface while the photoelectric conversion device is supported in a suspended manner such that the likelihood of distortion or breaking of the interface is reduced.

With the aim of advantageously solving the problems set forth above, the presently disclosed photoelectric conversion device preferably further comprises a third connection unit disposed on at least one of the rigid members at an opposite surface to the surface at which the second connection unit is disposed and configured to collectively detach photoelectric conversion module groups connected to the rigid members. In a situation in which a plurality of photoelectric conversion module groups is connected, this configuration facilitates detachment of the photoelectric conversion module groups and thereby enables improvement of convenience.

With the aim of advantageously solving the problems set forth above, in the presently disclosed photoelectric conversion device, it is preferable that the rigid members each have a length that is roughly equivalent to a transverse direction length of a photoelectric conversion module connected thereto. In this configuration, the width direction size of the rigid members can be restricted and an increase in two-dimensional size of the interface when folded can be inhibited, which enables improvement of portability.

With the aim of advantageously solving the problems set forth above, in the presently disclosed photoelectric conversion device, it is preferable that the rigid members each have a width that is roughly 1/3 of a width of a photoelectric conversion module included in the photoelectric conversion module group. In this configuration, the width direction size of the rigid members can be restricted and an increase in two-dimensional size of the interface when folded can be inhibited, which enables improvement of portability and facilitates folding operation.

### (Advantageous Effect)

The presently disclosed photoelectric conversion device facilitates addition of solar cell module groups and enables improvement of convenience.

### BRIEF DESCRIPTION OF THE DRAWINGS

In the accompanying drawings:
FIG. 1 is a block diagram illustrating configuration of a photoelectric conversion device according to a disclosed embodiment;
FIG. 2 is a block diagram illustrating configuration of solar cell module groups illustrated in FIG. 1;
FIG. 3 illustrates an example of use of the photoelectric conversion device illustrated in FIG. 1;
FIG. 4 illustrates configuration of a solar cell module IF illustrated in FIG. 1;
FIG. 5 illustrates configuration of a rigid member included in an interface illustrated in FIG. 1;
FIG. 6 illustrates configuration of the interface illustrated in FIG. 1;
FIG. 7 illustrates a state in which the interface illustrated in FIG. 6 is folded;
FIG. 8 is a flowchart illustrating operation of the photoelectric conversion device illustrated in FIG. 1 during charging of a rechargeable battery;
FIG. 9 is a flowchart illustrating operation of the photoelectric conversion device illustrated in FIG. 1 during discharging to an external device;
FIG. 10 illustrates an example of a mode of use of the photoelectric conversion device illustrated in FIG. 1;
FIG. 11 illustrates another example of a mode of use of the photoelectric conversion device illustrated in FIG. 1;
FIG. 12 illustrates another example of a mode of use of the photoelectric conversion device illustrated in FIG. 1;
FIG. 13 illustrates another example of a mode of use of the photoelectric conversion device illustrated in FIG. 1;
FIG. 14 illustrates a state in which the interface and solar cell module groups illustrated in FIG. 1 are folded;
FIG. 15 illustrates another example of a mode of use of the photoelectric conversion device illustrated in FIG. 1;
FIG. 16 illustrates another example of configuration of the interface illustrated in FIG. 1;
FIG. 17 illustrates a state in which the interface illustrated in FIG. 16 is folded; and

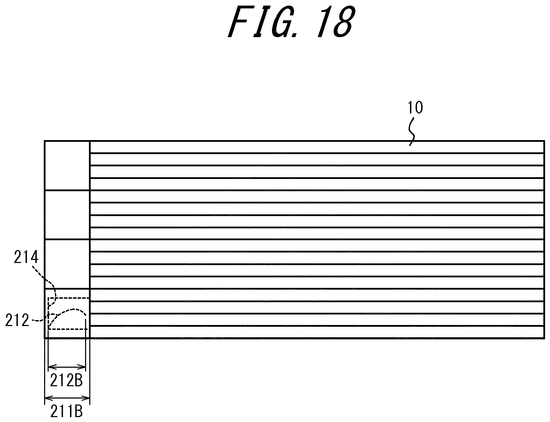

FIG. 18 is a side surface view of the interface illustrated in FIG. 1.

### DESCRIPTION OF EMBODIMENTS

The following provides a detailed description of disclosed embodiments.

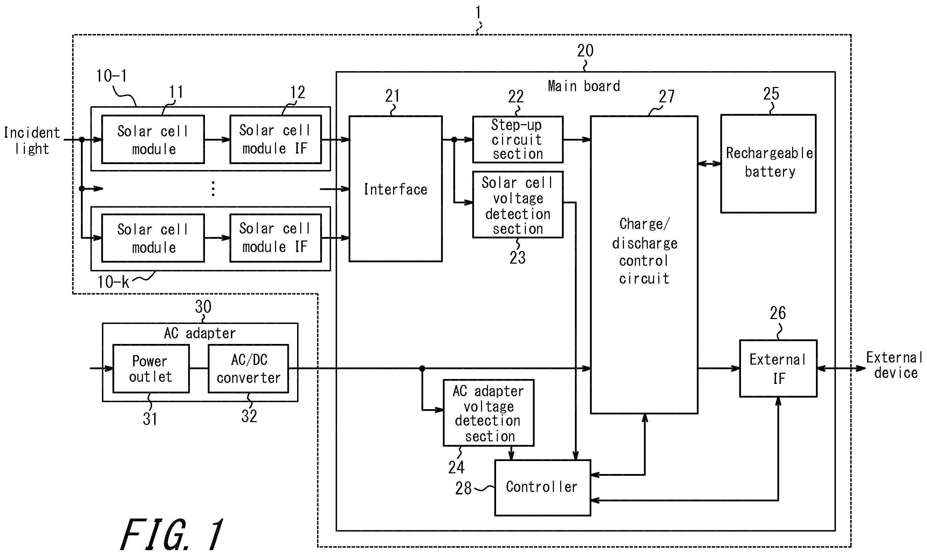

FIG. 1 is a block diagram illustrating configuration of a photoelectric conversion device 1 according to one disclosed embodiment.

In the photoelectric conversion device 1 according to the present embodiment, solar cell module groups 10 including solar cell modules are attached to a main board 20, and the main board 20 is configured to receive an electrical power supply from the solar cell module groups 10 (solar cell modules). The main board 20 may accumulate the supplied electrical power in the device or may supply the electrical power to a smartphone, tablet PC, or other external device via a specific interface, such as a universal serial bus (USB) interface. The photoelectric conversion device 1 can also receive an electrical power supply from a commercial power supply via an AC adapter 30. The AC adapter 30 includes a power outlet 31 and an AC/DC converter 32. The AC/DC converter 32 is configured to receive input of an AC voltage from the commercial power supply, via the power outlet 31, convert the input AC voltage to a DC voltage, and supply the DC voltage to the main board 20.

The photoelectric conversion device 1 illustrated in FIG. 1 includes a plurality of solar cell module groups (photoelectric conversion module groups) 10-1 to 10-k and the main board 20. In the following description, the solar cell module groups 10-1 to 10-k are each referred to simply as a solar cell module group 10 when it is not necessary to distinguish therebetween.

The solar cell module groups 10 each include at least one solar cell module 11 and a solar cell module interface (IF) 12.

The solar cell module 11 is a photoelectric conversion module including at least one solar cell that photoelectrically converts incident light, such as sunlight or room light, and outputs electrical power.

In terms of type, solar cells are broadly classified as inorganic solar cells in which an inorganic material is used and organic solar cells in which an organic material is used. Examples of inorganic solar cells include Si solar cells in which Si is used and compound solar cells in which a compound is used. Examples of organic solar cells include thin-film solar cells such as small molecule vapor deposition-type solar cells in which an organic pigment is used, polymer coating-type solar cells in which a conductive polymer is used, and coating-conversion-type solar cells in which a conversion-type semiconductor is used; and dye-sensitized solar cells formed from titania, an organic dye, and an electrolyte. Other examples of solar cells include organic/inorganic hybrid solar cells and solar cells in which a perovskite compound is used. Herein, any of these types of solar cells can be used. However, generally, organic solar cells are suitable for use herein since organic solar cells can be provided with a thin and flexible configuration.

The solar cell module IF 12 is an interface for attaching a solar cell module group 10 to the main board 20 and providing electrical and mechanical connection therebetween. The solar cell module IF 12 is described in detail further below.

The main board 20 includes an interface (IF) 21, a step-up circuit section 22, a solar cell voltage detection section 23, an AC adapter voltage detection section 24, a rechargeable battery 25, an external interface (IF) 26, a charge/discharge control circuit 27, and a controller 28.

The interface 21 attaches one or more solar cell module groups 10 to the main board 20 and provides electrical and mechanical connection (linkage) therebetween. The interface 21 is configured to receive a voltage supplied from each attached solar cell module group 10 (solar cell module 11), via the solar cell module IF 12, and supply the voltage to the step-up circuit section 22. Note that the interface 21 enables attachment of a plurality of solar cell module groups 10. The interface 21 is described in detail further below.

The step-up circuit section 22 is configured to receive a voltage supplied from the solar cell module groups 10, via the interface 21, raise the supplied voltage to a specific voltage required for charging the rechargeable battery 25, and output the raised voltage to the charge/discharge control circuit 27.

The solar cell voltage detection section 23 is configured to detect a voltage (solar cell voltage) that is supplied to the step-up circuit section 22, via the interface 21, from the solar cell module groups 10 (solar cell modules 11) attached to the main board 20, and output the result of the detection to the controller 28.

The AC adapter voltage detection section 24 is configured to detect a voltage (AC adapter voltage) that is supplied to the charge/discharge control circuit 27 from the AC adapter 30, and output the result of the detection to the controller 28.

The rechargeable battery 25 is a battery that can be charged and discharged, such as a lead-acid battery or a lithium ion secondary battery.

The external IF 26 is, for example, an interface such as a USB interface for connecting the photoelectric conversion device 1 to an external device.

The charge/discharge control circuit 27 is configured to control charging and discharging between the step-up circuit section 22, the AC adapter 30, the rechargeable battery 25, and the external device connected via the external IF 26.

The controller 28 is configured to control operation of each section of the main board 20. For example, the controller 28 controls the charge/discharge control circuit 27 to control paths for charging and discharging based on the detection result of the solar cell voltage detection section 23, the detection result of the AC adapter voltage detection section 24, and the charge level of the rechargeable battery 25. Moreover, the controller 28, for example, controls voltage-raising operation of the step-up circuit section 22.

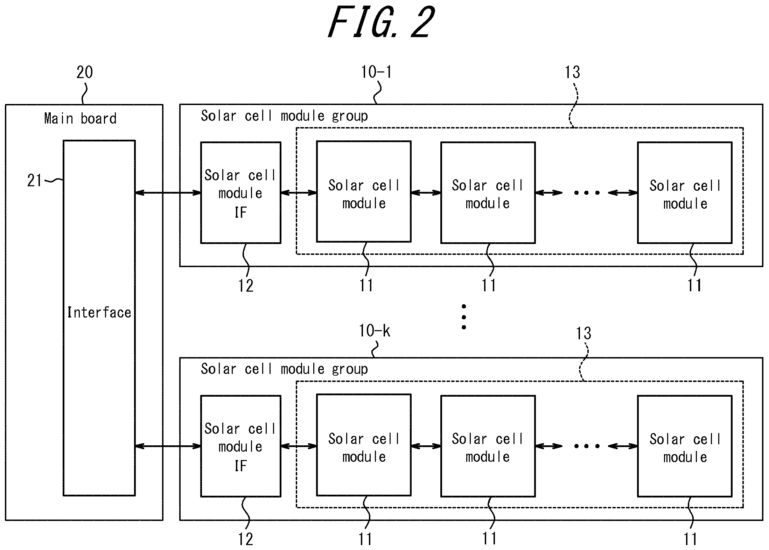

Next, configuration of the solar cell module groups 10 is described in more detail with reference to the block diagram illustrated in FIG. 2.

The solar cell module groups 10 illustrated in FIG. 2 each include a solar cell module set 13 and a solar cell module IF 12.

The solar cell module set 13 includes at least one solar cell module 11. In a situation in which the solar cell module set 13 includes a plurality of solar cell modules 11, the solar cell modules 11 are arranged with a specific spacing therebetween and adjacent solar cell modules 11 are in cascade connection. One of the solar cell modules 11 (solar cell module 11 positioned at one end of the column of solar cell modules 11 in the example illustrated in FIG. 2) is connected to the solar cell module IF 12. In a state in which the solar cell module group 10 is attached to the interface 21 of the main board 20, the total of output voltages of the solar cell modules 11 included in the solar cell module set 13 is supplied to the main board 20 via the solar cell module IF 12. As previously explained, a plurality of solar cell module groups 10 can be attached to the interface 21 of the main board 20, and the main board 20 can receive an electrical power supply from each of the attached solar cell module groups 10. Therefore, the electrical power supplied to the main board 20 can be adjusted by altering the number of solar cell module groups 10 attached to the main board 20.

In a situation in which a solar cell module group 10 includes a plurality of solar cell modules 11, electrodes of the solar cell modules 11 are, for example, connected by a flexible substrate. Through this configuration, the solar cell module group 10 can be folded at a section between adjacent solar cell modules 11. Consequently, the solar cell module group 10 can be spread out during use and can be folded when not in use such as to facilitate storage and transport.

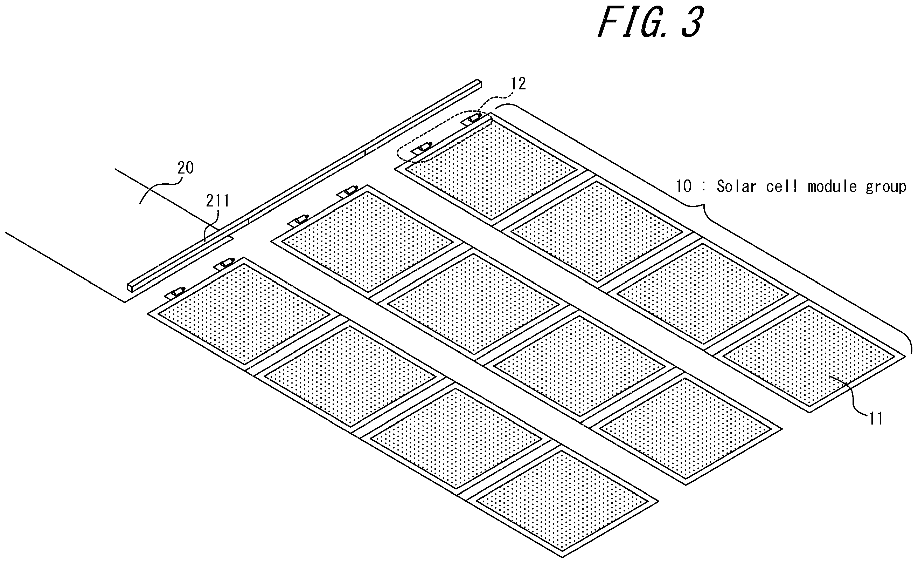

FIG. 3 illustrates an example of use of the photoelectric conversion device 1 according to the present embodiment.

As illustrated in FIG. 3, the interface 21 is disposed on the main board 20 of the photoelectric conversion device 1. At least one solar cell module group 10 is connected to the interface 21, via a solar cell module IF 12, in an spread-out state. In this configuration, the solar cell modules 11 can convert incident light to electrical power and supply this electrical power to the main board 20 of the photoelectric conversion device 1 via the solar cell module IF 12 and the interface 21.

FIG. 3 illustrates an example in which each of the solar cell module groups 10 includes a plurality of solar cell modules 11. In this case, the solar cell module IF 12 is disposed in a direction that intersects the arrangement direction of the solar cell modules 11 (i.e., in a transverse direction of the solar cell module group 10). This restricts the length of the interface 21 compared to in a situation in which a long edge of the solar cell module group 10 and the interface 21 are connected, while also enabling attachment of a plurality of solar cell module groups 10.

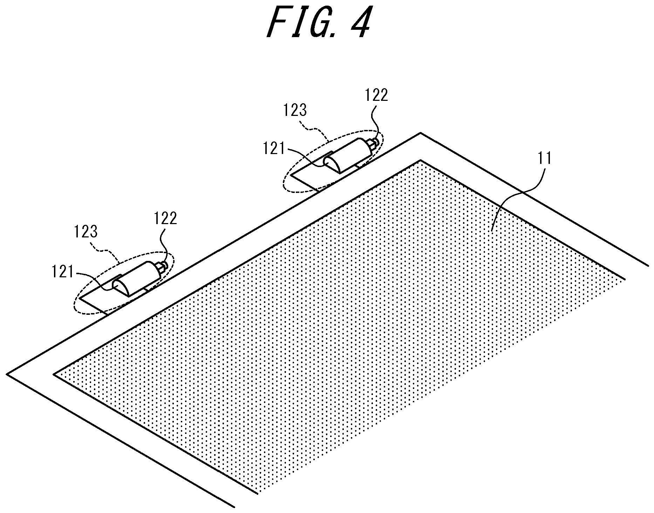

Next, configuration of the solar cell module IF 12 is described with reference to FIG. 4.

The solar cell module IF 12 illustrated in FIG. 4 includes guides 121 (first connecting portions) and connectors 122 (first connectors). The guides 121 and the connectors 122 form first connection unit 123.

Each of the guides 121 is a member that has a specific cross-sectional shape (for example, a semicircle) and extends in the transverse direction of the solar cell module group 10 as previously described.

The connectors 122 are each attached to a tip of a corresponding guide 121 (end of the guide 121 in a backward direction relative to the plane of the drawing in FIG. 4). The guides 121 and the connectors 122 are provided in an integrated form (i.e., each guide 121 is bound to the corresponding connector 122). The connectors 122 are electrically connected to an electrode of one of the solar cell modules 11 in the solar cell module set 13 of the solar cell module group 10. The connectors 122 may, for example, each be a male structure of a pin connector.

Next, configuration of the interface 21 is described.

As previously explained, a plurality of solar cell module groups 10 can be connected to the interface 21. The interface 21 is formed by a plurality of linked rigid members. One or more solar cell module groups 10 are connected to each of the rigid members.

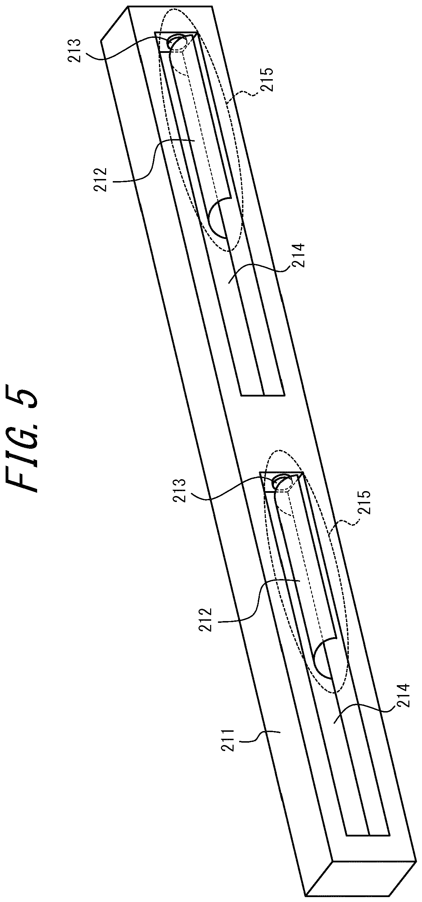

The following describes configuration of the rigid members forming the interface 21 with reference to FIG. 5.

A rigid member 211 illustrated in FIG. 5 includes guide rails 212 (second connecting portions) and connectors 213 (second connectors). The guide rails 212 and the connectors 213 form second connection unit 215.

The guide rails 212 are each disposed in a recess 214 in one surface of the rigid member 211. The guide rails 212 are columnar members having a cross-sectional shape (for example, a hollow semicircle) that corresponds to the guides 121 of the solar cell module IF 12. The guide rails 212 can receive insertion of the guides 121 of the solar cell module IF 12 into the hollow portions thereof, and can be slid against (brought into contact with such as to slide) and engaged with the guides 121. In the example illustrated in FIG. 5, the guides 121 are each inserted from the front of the corresponding guide rail 212, relative to the plane of the drawing, toward an innermost part of the guide rail 212.

The connectors 213 are disposed at positions such as to be connected to the connectors 122 of the solar cell module IF 12 in a state in which the guides 121 are engaged with the guide rails 212 at specific positions. The connectors 213 may, for example, each be a female structure of a pin connector.

As illustrated in FIG. 4, the connectors 122 of the solar cell module IF 12 are disposed at the tips of the guides 121. In this case, the connectors 213 of the rigid member 211 are, for example, each disposed around the innermost part of the corresponding guide rail 212 such that the connectors 122 and the connectors 213 become connected when the guides 121 are each inserted to the innermost part of the corresponding guide rail 212.

The engagement of the guides 121 and the guide rails 212 mechanically connects the solar cell module group 10 and the main board 20. Moreover, the connection of the connectors 122 and the connectors 213 that accompanies the engagement of the guides 121 and the guide rails 212 electrically connects the solar cell module group 10 and the main board 20. In this manner, the solar cell module group 10 and the main board 20 can be electrically and mechanically connected in the present embodiment through a simple operation of sliding the guides 121 of the solar cell module IF 12 along the guide rails 212 of the rigid member 211.

It should be noted that the shape of the guides 121 and the guide rails 212 is not limited to a semicircular shape and may be any of a variety of shapes such as a trapezoidal shape. In other words, the guides 121 and the guide rails 212 may have any shape so long as the guides 121 and the guide rails 212 can slide against and engage with one another. However, a configuration in which the guides 121 each have a semicircular shape or a trapezoidal shape and the guide rails 212 each have a shape corresponding to the shape of the guides 121 can prevent reverse insertion in which the solar cell module group 10 is attached with the front and back thereof reversed.

Although an example is described in the present embodiment in which the guides 121 are disposed on the solar cell module IF 12 and the guide rails 212 are disposed on the rigid member 211, this is not a limitation. Alternatively, guide rails may be disposed on the solar cell module IF 12 and guides may be disposed on the rigid member 211.

Furthermore, the number, size, width, positioning, and so forth of guides and guide rails may be freely set so long as the guides and guide rails can slide against and engage with one another.

The number, positioning, and so forth of the connectors 122 and the connectors 213 can also be freely set so long as the connectors 122 and the connectors 213 are connectable in a state in which the guides and the guide rails are engaged.

Furthermore, although an example is described in the present embodiment in which the connectors 122 are each a male structure of a pin connector and the connectors 213 are each a female structure of a pin connector, this is not a limitation. Alternatively, the connectors 122 may each be a female structure of a pin connector and the connectors 213 may each be a male structure of a pin connector.

Moreover, the first connection unit 123 and the second connection unit 215 may be connected by a card edge method in which a card edge connector is inserted into an edge connector socket.

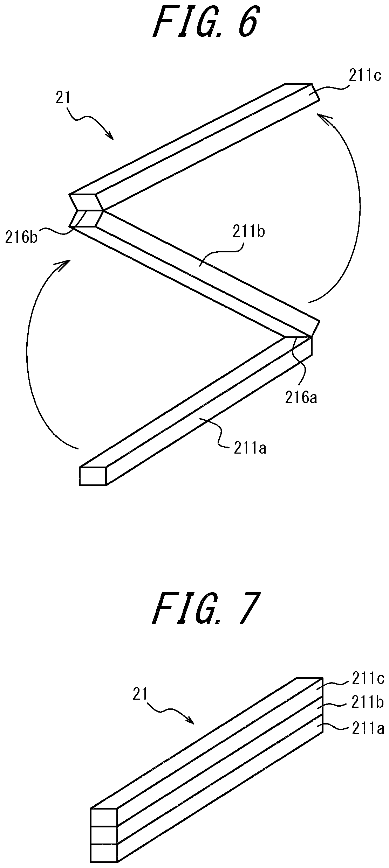

As previously described, the interface 21 is formed from a plurality of rigid members 211. FIG. 6 illustrates configuration of the interface 21.

In the example illustrated in FIG. 6, the interface 21 includes three rigid members 211 (211a, 211b, 211c).

The rigid member 211a and the rigid member 211b are connected in a foldable (openable and closeable) manner via a linking portion 216a, and the rigid member 211b and the rigid member 211c are connected in an openable and closeable manner via a linking portion 216b.

The linking portion 216a is formed from a hinge that mechanically connects the rigid member 211a and the rigid member 211b, and a flexible conductive member (for example, a conductive cable or a flexible substrate) that electrically connects the connectors 213 of the rigid member 211a and the connectors 213 of the rigid member 211b. The linking portion 216b is formed from a hinge that mechanically connects the rigid member 211b and the rigid member 211c, and a flexible conductive member that electrically connects the connectors 213 of the rigid member 211b and the connectors 213 of the rigid member 211c. In this manner, two rigid members 211 are connected by one hinge in the present embodiment. It should be noted that there are various configurations that can be used to mechanically and electrically connect two units in an openable and closeable manner using a hinge and a conductive member, and explanation thereof is omitted since such configurations are well known by persons of ordinary skill in the technical field.

In this manner, adjacent rigid members 211 in the interface 21 are mechanically connected in an openable and closeable manner and electrically connected through the linking portion 216. Therefore, the interface 21 can be folded in terms of rigid member 211 units as illustrated in FIG. 7, and can also be extended in a linear shape as illustrated in FIG. 3.

As a result of the rigid members 211 being electrically connected as described above, the total of electrical power supplied from each solar cell module group 10 that is attached to the interface 21 is supplied to the main board 20. Therefore, the electrical power supplied to the main board 20 can be adjusted by adjusting the number and type of solar cell module groups 10 that are attached to the interface 21. Moreover, a solar cell module group 10 can be easily attached to and detached from the interface 21 (rigid member 211) in the present embodiment through a simple operation of sliding the guides 121 of the solar cell module IF 12 against the guide rails 212 of the rigid member 211 to engage or disengage the guides 121 and the guide rails 212. This facilitates adjustment of electrical power supplied to the main board 20 and enables improvement of convenience. Moreover, since the interface 21 is foldable, this enables storage in a small form when not in use, which provides excellent portability and enables improvement of convenience.

The second connection unit 215 are each disposed at a surface that, in a state in which adjacent rigid members 211 are folded, is not a surface at which the adjacent rigid members 211 oppose one another (i.e., are in contact). This configuration enables folding of the interface 21 such that even in a folded state, the thickness of the interface 21 does not exceed the total thickness of the folded rigid members 211. Moreover, the thickness of the interface 21 when folded can be reduced.

FIGS. 6 and 7 illustrate an example in which the number of rigid members 211 forming the interface 21 is three, but this is not a limitation. Alternatively, the number of rigid members 211 forming the interface 21 may be two or may be four or more.

In this manner, the photoelectric conversion device 1 according to the present embodiment includes an interface 21 to which at least one solar cell module group 10 is attached. The interface 21 includes a plurality of rigid members 211, each including a second connection unit 215 that is mechanically and electrically linkable to a first connection unit 123 of the solar cell module group 10. Moreover, the rigid members 211 are mechanically and electrically linked in a foldable manner.

This mechanical and electrical linking, in a foldable manner, of the rigid members 211, which each include a second connection unit 215 that is mechanically and electrically linkable to a first connection unit 123 of a solar cell module group 10, enables the attachment of a plurality of solar cell module groups 10 (i.e., addition of solar cell module groups 10), and thus enables improvement of convenience. Moreover, because the interface 21 is foldable in terms of rigid member 211 units, the interface 21 can be folded to a smallest unit (width of one rigid member 211) when not in use and can be stored in a small form. This provides excellent portability and enables improvement of convenience.

Moreover, each solar cell module group 10 is foldable in terms of solar cell module 11 units. Consequently, when the interface 21 and each solar cell module group 10 attached thereto are folded, it is possible to reduce the two-dimensional (planar) size to approximately the same size as a smallest folding unit of the solar cell module group 10 (for example, one solar cell module 11). This provides excellent portability and enables improvement of convenience. The two-dimensional size when the interface 21 and each solar cell module group 10 attached thereto are folded is not dependent on the number of rigid members 211 that are included, and thus an increase in device size can be suppressed even when the number of rigid members 211 is increased.

Moreover, by adopting the same configuration for the connection unit of each of the rigid members 211 of the interface 21 (i.e., by standardizing the connection unit), a non-connected solar cell module group 10 can be connected to an interface 21 (rigid member 211) of another photoelectric conversion device 1 for use. Furthermore, a mixture of solar cell module groups 10 that differ in terms of the form of solar cell modules 11 therein may be connected (added) to a single photoelectric conversion device 1. By adopting the same configuration for the connection unit (i.e., by standardizing the connection unit), it is possible to connect a solar cell module group 10 to another device that has a different mode of use of the solar cell module group 10 to the photoelectric conversion device 1, which enables improvement of compatibility. Moreover, in a situation in which a novel solar cell module group 10 having enhanced conversion efficiency, or the like, is subsequently developed, the newly developed solar cell module group 10 can also be connected to a rigid member 211 and used.

Furthermore, in a situation in which different configurations are adopted for the second connection unit 215 of each of the rigid members 211 of the interface 21, solar cell module groups 10 having first connection unit 123 corresponding to the second connection unit 215 of the rigid members 211 can be connected on a rigid member 211 unit basis such that different types of solar cell module groups 10 can be added (mixed), which enables improvement of the degree of freedom in connection.

Next, operation of the photoelectric conversion device 1 according to the present embodiment is described.

The photoelectric conversion device 1 according to the present embodiment is configured to receive a charging request from an external device connected to the external IF 26 and supply electrical power to the external device via the external IF 26. There are three supply sources for supplying electrical power to the external device. These supply sources are the one or more solar cell module groups 10 attached to the main board 20, the AC adapter 30, and the rechargeable battery 25 of the main board 20. The photoelectric conversion device 1 is configured to select an appropriate supply source for supplying electrical power to the external device from among these supply sources and supply electrical power to the external device connected to the external IF 26.

Moreover, the photoelectric conversion device 1 according to the present embodiment is configured to charge the rechargeable battery 25 using the one or more solar cell module groups 10 attached to the main board 20 or the AC adapter 30 as a supply source of electrical power. The photoelectric conversion device 1 is configured to select a suitable supply source for supplying electrical power to the rechargeable battery 25 from among these supply sources and charge the rechargeable battery 25.

The following describes operation of the photoelectric conversion device 1 during charging of the rechargeable battery 25 and during discharging to the external device. First, operation during charging of the rechargeable battery 25 is described.

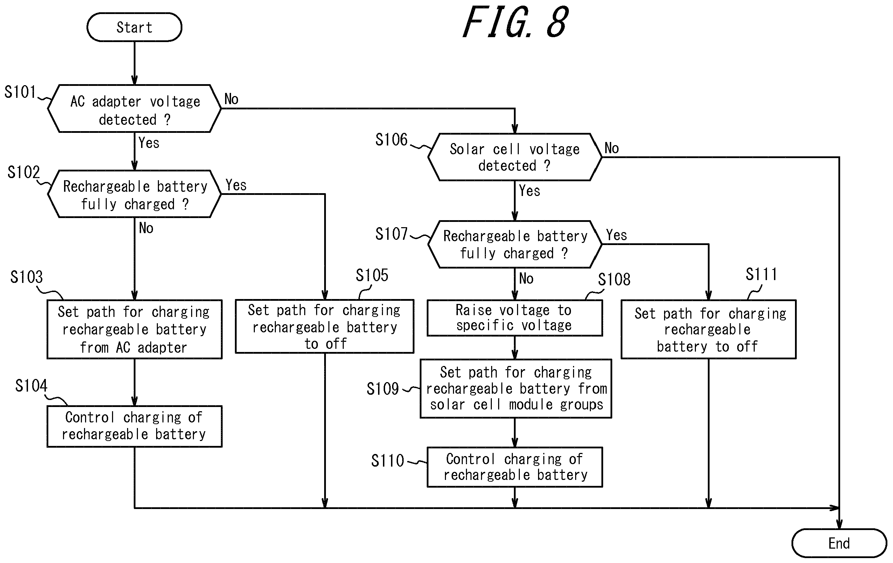

FIG. 8 is a flowchart illustrating operation of the photoelectric conversion device 1 during charging of the rechargeable battery 25.

The controller 28 determines whether or not an AC adapter voltage is detected from output of the AC adapter voltage detection section 24 (Step S101).

In a situation in which the controller 28 determines that an AC adapter voltage is detected (Step S101: Yes), the controller 28 determines whether or not the rechargeable battery 25 is fully charged (Step S102).

In a situation in which the controller 28 determines that the rechargeable battery 25 is not fully charged (Step S102: No), the controller 28 controls the charge/discharge control circuit 27 to set a path for charging of the rechargeable battery 25 from the AC adapter 30 (Step S103). The charge/discharge control circuit 27 controls charging of the rechargeable battery 25 in accordance with the set path (Step S104). It should be noted that description of methods for controlling charging of the rechargeable battery 25 is omitted since such methods are well known by persons of ordinary skill in the technical field and are not directly related to this disclosure.

In a situation in which the controller 28 determines that the rechargeable battery 25 is fully charged (Step S102: Yes), the controller 28 controls the charge/discharge control circuit 27 to set the path for charging of the rechargeable battery 25 to off (Step S105).

In a situation in which the controller 28 determines that an AC adapter voltage is not detected (Step S101: No), the controller 28 determines whether or not a solar cell voltage is detected from output of the solar cell voltage detection section 23 (Step S106).

In a situation in which the controller 28 determines that a solar cell voltage is detected (Step S106: Yes), the controller 28 determines whether or not the rechargeable battery 25 is fully charged (Step S107).

In a situation in which the controller 28 determines that the rechargeable battery 25 is not fully charged (Step S107: No), the controller 28 causes the step-up circuit section 22 to raise a voltage supplied from the solar cell module groups 10 via the interface 21 (Step S108). In addition, the controller 28 controls the charge/discharge control circuit 27 to set a path for charging of the rechargeable battery 25 from the solar cell module groups 10 (Step S109). The charge/discharge control circuit 27 controls charging of the rechargeable battery 25 in accordance with the set path (Step S110).

In a situation in which the controller 28 determines that the rechargeable battery 25 is fully charged (Step S107: Yes), the controller 28 controls the charge/discharge control circuit 27 to set the path for charging of the rechargeable battery 25 to off (Step S111).

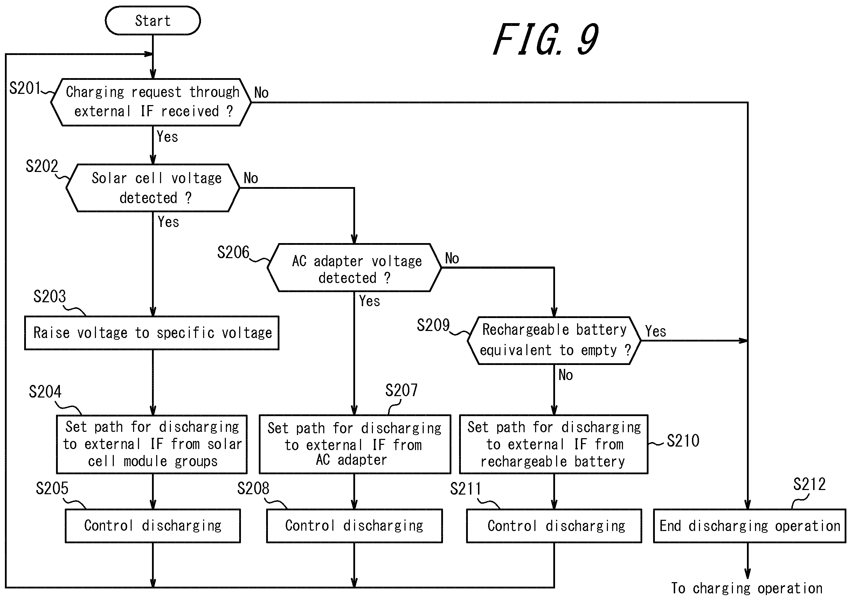

After the rechargeable battery 25 is fully charged through the control of charging in Step S104 or Step S110, after the path for charging of the rechargeable battery 25 is set to off through processing in Step S105 or Step Sill, or in a situation in which the controller 28 determines that a solar cell voltage is not detected (Step S106: No), the controller 28 ends the charging operation and proceeds to a discharging operation illustrated in FIG. 9.

FIG. 9 is a flowchart illustrating operation of the photoelectric conversion device 1 during discharging to an external device.

First, the controller 28 determines whether or not a charging request is received from an external device via the external IF 26 (Step S201).

In a situation in which the controller 28 determines that a charging request is received from an external device via the external IF 26 (Step S201: Yes), the controller 28 determines whether or not a solar cell voltage is detected from output of the solar cell voltage detection section 23 (Step S202).

In a situation in which the controller 28 determines that a solar cell voltage is detected (Step S202: Yes), the controller 28 causes the step-up circuit section 22 to raise a voltage supplied from the solar cell module groups 10 via the interface 21 (Step S203). In addition, the controller 28 controls the charge/discharge control circuit 27 to set a path for discharging to the external IF 26 from the solar cell module groups 10 (Step S204). The charge/discharge control circuit 27 controls discharging to the external IF 26 from the solar cell module groups 10 in accordance with the set path (Step S205). As a result, electrical power is supplied to the external device from the solar cell module groups 10, via the external IF 26. It should be noted that description of methods for controlling discharging to the external IF 26 is omitted since such methods are well known by persons of ordinary skill in the technical field and are not directly related to this disclosure.

In a situation in which the controller 28 determines that a solar cell voltage is not detected (Step S202: No), the controller 28 determines whether or not an AC adapter voltage is detected from output of the AC adapter voltage detection section 24 (Step S206).

In a situation in which the controller 28 determines that an AC adapter voltage is detected (Step S206: Yes), the controller 28 controls the charge/discharge control circuit 27 to set a path for discharging to the external IF 26 from the AC adapter 30 (Step S207). The charge/discharge control circuit 27 controls discharging to the external IF 26 from the AC adapter 30 in accordance with the set path (Step S208). As a result, electrical power is supplied to the external device from the AC adapter 30, via the external IF 26.

In a situation in which the controller 28 determines that an AC adapter voltage is not detected (Step S206: No), the controller 28 determines whether or not the charge level of the rechargeable battery 25 is equivalent to empty (Step S209).

In a situation in which the controller 28 determines that the charge level of the rechargeable battery 25 is not equivalent to empty (Step S209: No), the controller 28 controls the charge/discharge control circuit 27 to set a path for discharging to the external IF 26 from the rechargeable battery 25 (Step S210). The charge/discharge control circuit 27 controls discharging to the external IF 26 from the rechargeable battery 25 in accordance with the set path (Step S211). As a result, electrical power is supplied to the external device from the rechargeable battery 25, via the external IF 26.

After control of discharge by the charge/discharge control circuit 27 ends in Step S205, Step S208, or Step S211, the controller 28 returns to Step S201 and determines whether or not there is a charging request.

In a situation in which the controller 28 determines that a charging request is not received from an external device (Step S201: No) or in a situation in which the controller 28 determines that the charge level of the rechargeable battery 25 is equivalent to empty (Step S209: Yes), the controller 28 ends the discharging operation (Step S212) and returns to the charging operation illustrated in FIG. 8.

Next, an example of use of the photoelectric conversion device 1 according to the present embodiment is described.

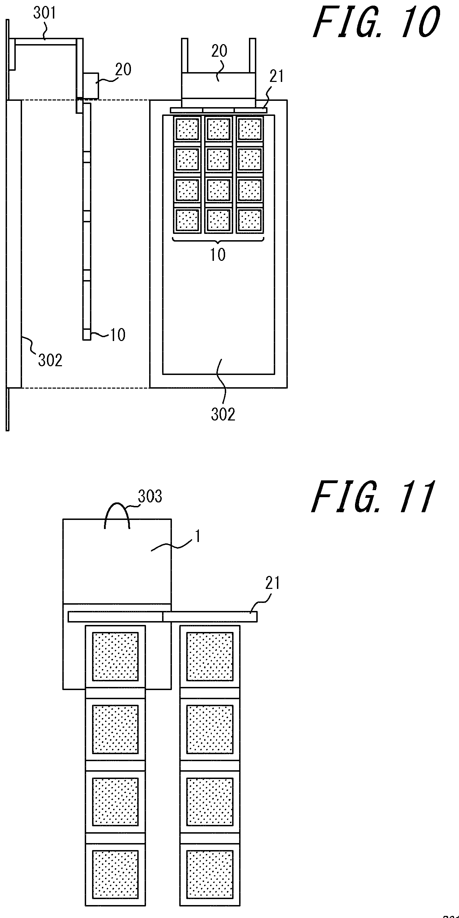

When a user is at home, the photoelectric conversion device 1 may, for example, be set up near a window 302, through a support 301, in a state in which a plurality of solar cell module groups 10 are attached to the interface 21. In a situation in which the solar cell module groups 10 are, for example, spread out in a plane on a desk, or the like, for use, the solar cell module groups 10 take up space, making the photoelectric conversion device 1 inconvenient to use. Therefore, supporting the photoelectric conversion device 1 (solar cell module groups 10) in a suspended manner as illustrated in FIG. 10 enables space-saving during set up.

Moreover, when the user goes out, the user may take some of the solar cell module groups 10 set up near the window with them as necessary, and may attach these solar cell module groups 10 to the interface 21 as illustrated in FIG. 11 during use. This is one example of use of the photoelectric conversion device 1 that is envisaged.

Note that the photoelectric conversion device 1 may include a supporting portion 303 (first support unit) for supporting the photoelectric conversion device 1 as illustrated in FIG. 11.

By providing the photoelectric conversion device 1 with the supporting portion 303, the photoelectric conversion device 1 (solar cell module groups 10) can be supported in a suspended state even in a situation such as when the user goes out.

As previously explained, the interface 21 is formed from the plurality of rigid members 211 such that a plurality of solar cell module groups 10 can be attached. Accordingly, the length of the interface 21 in a state in which the interface 21 is spread out is normally long compared to the width of the main body of the photoelectric conversion device 1. Consequently, suspension stress that acts on the interface 21 when the photoelectric conversion device 1 is supported in a suspended state by just the supporting portion 303 may cause deformation or breaking of the interface 21.

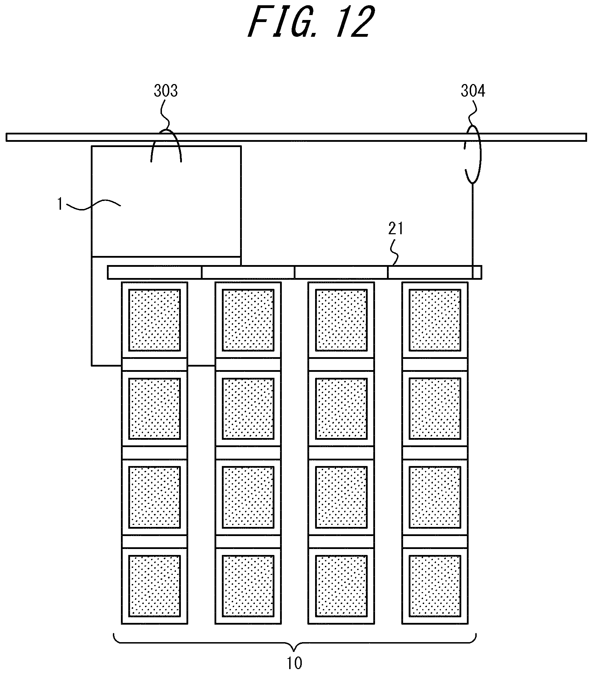

Therefore, it is preferable to provide a supporting portion 304 (second support unit) on the interface 21 that supports the interface 21 as illustrated in FIG. 12 when the photoelectric conversion device 1 is supported in a suspended state by the supporting portion 303. Through provision of the supporting portion 304, the suspension stress acting on the interface 21 can be distributed such that the likelihood of deformation or breaking of the interface 21 is reduced.

Although FIG. 12 illustrates an example in which only one supporting portion 304 is provided, this is not a limitation, and a plurality of supporting portion 304 may be provided.

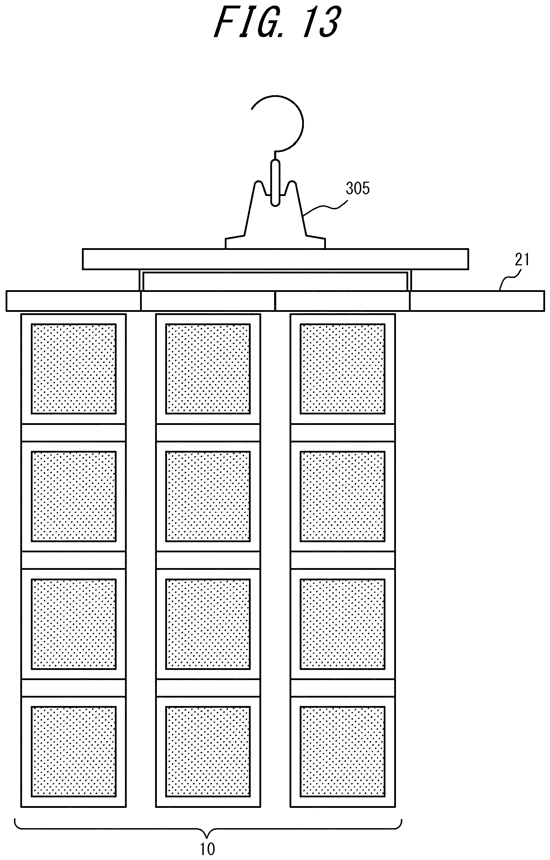

Moreover, the photoelectric conversion device 1 may include a hanger-shaped suspending member 305 that supports the photoelectric conversion device 1 as illustrated in FIG. 13 with the solar cell module groups 10 attached to the interface 21 in a suspended state.

In a situation in which the photoelectric conversion device 1 is supported by the support 301 set up near the window 302 as illustrated in FIG. 10, the set-up position of the photoelectric conversion device 1 is limited to near the window 302. In contrast, by providing the suspending member 305 that supports the photoelectric conversion device 1 as illustrated in FIG. 13, the user can set up the photoelectric conversion device 1 more freely.

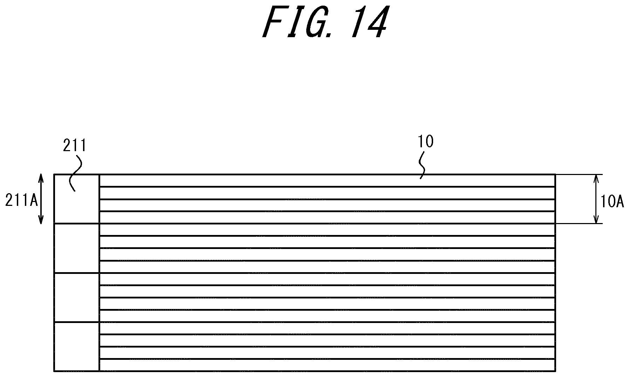

In the present embodiment, the interface 21 is foldable in terms of rigid member 211 units as previously described. Moreover, the solar cell module groups 10 are also foldable. Therefore, it is preferable that the rigid members 211 each have a thickness 211A that is roughly equivalent to the thickness 10A of a solar cell module group 10 when folded as illustrated in FIG. 14. Through this configuration, in a state in which a solar cell module group 10 is attached to each of the rigid members 211 of the interface 21, the thickness of the interface 21 when folded is roughly equivalent to the thickness of the solar cell module groups 10 when folded, which enables improvement of portability and storability. Moreover, the thickness of the interface 21 and the solar cell module groups 10 when folded can be reduced as thinner solar cell modules 11 are developed.

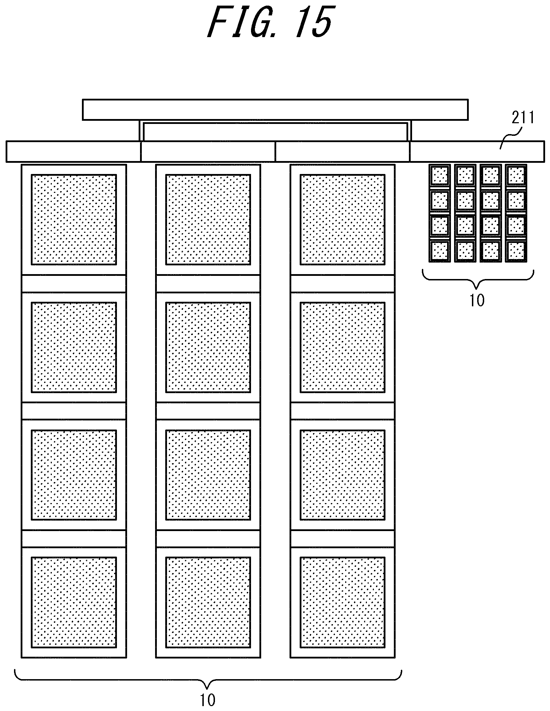

It should be noted that although an example is described in which one solar cell module group 10 is attached to one rigid member 211 in the present embodiment, this is not a limitation. In recent years, smaller solar cell modules 11 have been developed, thereby also enabling miniaturization of solar cell module groups 10. In response to such development, a plurality of solar cell module groups 10 may be attached to one rigid member 211 as illustrated in FIG. 15. This configuration increases the portability of the solar cell module groups 10 and enables finer adjustment of electrical power supplied to the main board 20.

In the present embodiment, solar cell module groups 10 can be easily attached to and detached from the interface 21 of the photoelectric conversion device 1 as previously described. Therefore, so long as compatibility between the first connection unit 123 and the second connection unit 215 is ensured, various types of solar cell module groups 10 (for example, differing in terms of manufacturer, suppliable electrical power, or type of solar cell modules 11) can be connected interchangeably, which enables improvement of convenience. Moreover, in a situation in which a structure corresponding to the main board 20 of the photoelectric conversion device 1 is provided at a location that the user visits while out, the user only needs to carry the necessary solar cell module groups 10, which enables improvement of convenience.

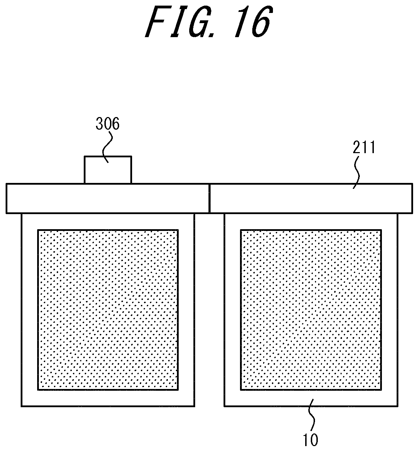

In the present embodiment, a third connection unit 306 may be disposed on one or more of the rigid members 211 forming the interface 21 as illustrated in FIG. 16.

The third connection unit 306 is disposed at an opposite surface of the rigid member 211 to the surface at which the second connection unit 215 is disposed (surface at which a solar cell module group 10 is connected) and is configured to collectively detach solar cell module groups 10 connected to the rigid members 211 of the interface 21. For example, there are various configurations that can be used to collectively detach a plurality of members (solar cell module groups 10) that are connected to a single member (interface 21) through guides 121 and guide rails 212. Although detailed description of such configurations is omitted for this reason, in one example of a configuration that may be adopted, a pressing member that presses the guides 121 in an opposite direction relative to during connection is provided on each rigid member 211 and operation of the third connection unit 306 causes the pressing member of each of the rigid members 211 to press the guides 121 of the solar cell module group 10 connected to the rigid member 211 in the opposite direction relative to during connection.

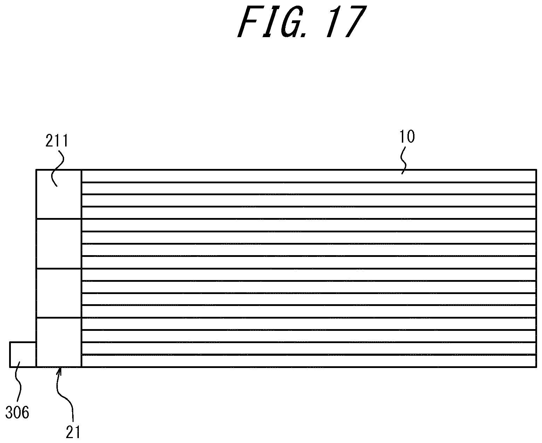

Through provision of the third connection unit 306 that enables collective detachment of solar cell module groups 10 connected to the interface 21 as described above, solar cell module groups 10 can be easily detached even when a plurality of solar cell module groups 10 is connected, which enables improvement of convenience. Once the rechargeable battery 25 is fully charged, an external device can be connected to the external IF 26 of the main board 20 and used in a state in which the interface 21 and the solar cell module groups 10 are folded as illustrated in FIG. 17. This enables space-saving during use, improves portability, and simplifies detachment of the solar cell module groups 10.

The length of each of the rigid members 211 is, for example, preferably roughly equivalent to the transverse direction length of a solar cell module group 10 (length of an edge connected to the rigid member 211) as illustrated in FIG. 3. Through this configuration, the length direction size of the rigid members 211 can be restricted and an increase in two-dimensional size of the interface 21 when folded can be suppressed, which enables improvement of portability and facilitates an operation of folding.

As illustrated in FIG. 5, the guide rails 212 (second connecting portions) of each of the rigid members 211 are disposed in the recesses 214 of the rigid member 211. In such a situation, it is preferable that, in terms of the connection direction of the interface 21 and the solar cell module groups 10, the width 211B of each of the rigid members 211 and the width 212B of each of the guide rails 212 are roughly equivalent. Through this configuration, the width direction size of the rigid members 211 can be restricted and an increase in two-dimensional size of the interface 21 when folded can be suppressed, which enables improvement of portability. The width 211B of each of the rigid members 211 is preferably approximately 1/3 of the width of a solar cell module 11 or less. This configuration ensures functionality when folded and suppresses an increase in two-dimensional size of the interface 21 when folded while enabling improvement of portability.

It should be noted that although the presently disclosed photoelectric conversion device has been described herein based on the drawings and embodiments, various modifications and revisions can easily be made by persons of ordinary skill in the technical field based on this disclosure. Therefore, such modifications and revisions should also be considered to be included within the scope of this disclosure. For example, the functions of blocks, or the like, may be rearranged so long as no logical contradiction arises, and blocks may be combined as a single block or may be split up.

### INDUSTRIAL APPLICABILITY

According to this disclosure, it is possible to provide a photoelectric conversion device that facilitates addition of solar cell module groups and enables improvement of convenience.

### REFERENCE SIGNS LIST

- 1: photoelectric conversion device
- 10: solar cell module group
- 11: solar cell module
- 12: solar cell module interface
- 20: main board
- 21: interface
- 22: step-up circuit section
- 23: solar cell voltage detection section
- 24: AC adapter voltage detection section
- 25: rechargeable battery
- 26: external interface
- 27: charge/discharge control circuit
- 28: controller
- 30: AC adapter
- 31: power outlet
- 32: AC/DC converter
- 121: guide
- 122: connector
- 123: first connection unit
- 211: rigid member
- 212: guide rail
- 213: connector
- 215: second connection unit
- 216: linking portion
- 301: support
- 302: window
- 303, 304: supporting portion
- 305: suspending member
- 306: third connection unit

## Claims

1. A photoelectric conversion device comprising an interface to which at least one photoelectric conversion module group is attached and configured to receive an electrical power supply from the photoelectric conversion module group that is attached to the interface, wherein
the interface includes:
a plurality of rigid members, each including a second connection unit that is mechanically and electrically linkable to a first connection unit of the photoelectric conversion module group; and
one or more linking portions that mechanically and electrically link the rigid members in a foldable manner.

2. The photoelectric conversion device according to claim 1, wherein the photoelectric conversion module group includes a plurality of photoelectric conversion modules in cascade connection and is foldable between adjacent photoelectric conversion modules.

3. The photoelectric conversion device according to claim 1 or 2, wherein
the second connection unit is disposed at a surface that, in a state in which adjacent rigid members are folded, is not a surface at which the adjacent rigid members oppose one another.

4. The photoelectric conversion device according to any one of claims 1 to 3, wherein
the rigid members each have a thickness that is roughly equivalent to a thickness of a photoelectric conversion module group connected thereto when the photoelectric conversion module group is folded.

5. The photoelectric conversion device according to any one of claims 1 to 4, wherein
the second connection unit includes:
a second connecting portion that is configured to slide against and engage with a first connecting portion of the first connection unit; and
a second connector that is configured to connect to a first connector of the first connection unit in a state in which the first connecting portion is at a specific position.

6. The photoelectric conversion device according to claim 5, wherein one of the first connecting portion and the second connecting portion is a guide rail and the other of the first connecting portion and the second connecting portion is a guide that slides against and engages with the guide rail.

7. The photoelectric conversion device according to claim 5 or 6, wherein
the rigid members each have a width that is roughly equivalent to a width of the second connecting portion.

8. The photoelectric conversion device according to any one of claims 1 to 4, wherein
one of the first connection unit and the second connection unit is a card edge connector and the other of the first connection unit and the second connection unit is an edge connector socket into which the card edge connector is inserted.

9. The photoelectric conversion device according to any one of claims 1 to 8, further comprising
a first support unit configured to support the photoelectric conversion device in a suspended manner.

10. The photoelectric conversion device according to claim 9, further comprising
a second support unit disposed on the interface and configured to support the interface in a state in which the photoelectric conversion device is supported in a suspended manner by the first support unit.

11. The photoelectric conversion device according to any one of claims 1 to 10, further comprising
a third connection unit disposed on at least one of the rigid members at an opposite surface to the surface at which the second connection unit is disposed and configured to collectively detach photoelectric conversion module groups connected to the rigid members.

12. The photoelectric conversion device according to any one of claims 1 to 11, wherein
the rigid members each have a length that is roughly equivalent to a transverse direction length of a photoelectric conversion module connected thereto.

13. The photoelectric conversion device according to any one of claims 1 to 12, wherein
the rigid members each have a width that is roughly 1/3 of a width of a photoelectric conversion module included in the photoelectric conversion module group.
